# DEMANDE DE BREVET EUROPEEN

(11) **EP 1 835 050 A1**
(43) Date de publication de la demande: **19.09.2007**
(21) Numéro de dépôt: 06405115.4
(22) Date de dépôt: 15.03.2006
(51) Int. Cl.: C25D 1/08

(54) **Procédé de fabrication par LIGA-UV d'une structure métallique multicouche à couches adjacentes non entièrement superposées, et structure obtenue**

(71) Demandeur: Doniar S.A., 2504 Bienne (CH)
(72) Inventeur: Saucy, Clément, 2520 La Neuveville (CH)
(74) Mandataire: Moinas, Michel

(57) **Abrégé**

Procédé de fabrication par LIGA-UV d'une structure métallique multicouche comportant au moins une deuxième couche adjacente à une première couche et non entièrement superposée à celle-ci, qui comprend les étapes suivantes :
a) étaler une couche de photorésist sur un substrat,
b) chauffer la couche de photorésist, si nécessaire pour évaporer le solvant,
c) exposer la couche de photorésist à travers un masque correspondant à l'empreinte désirée à une irradiation UV de 100 à 2000 mJ/cm² mesurée à une longueur d'onde de 365 nm,
d) effectuer, si nécessaire pour compléter la photopolymérisation ou la photodécomposition des parties irradiées, un recuit de la couche obtenue à l'issue de l'étape c),
e) procéder au développement par dissolution des parties non photopolymérisées ou photodécomposées, de façon à obtenir un moule de photorésist polymérisé,
f) déposer galvaniquement une première couche d'un métal ou d'un alliage dans les parties ouvertes du moule, et obtenir une surface supérieure sensiblement plane,
g) déposer par vaporisation sous vide une couche métallique d'accrochage sur toute la surface supérieure sensiblement plane, puis reproduire les étapes a), b), c), d) et e),
h) déposer galvaniquement une deuxième couche d'un métal ou d'un alliage dans les parties ouvertes du moule en présence de la couche métallique d'accrochage, et obtenir une surface supérieure sensiblement plane,
i) reproduire, si nécessaire, les étapes g) et h), de façon à former la structure métallique multicouche souhaitée, et
j) détacher du substrat la structure métallique multicouche obtenue et le photorésist polymérisé, séparer le photorésist de façon à libérer la structure métallique multicouche, puis éliminer la partie de la ou des couches métalliques d'accrochage qui n'est pas insérée entre deux couches de métal électrodéposé,
ainsi qu'une nouvelle structure métallique multicouche à couches adjacentes non entièrement superposées susceptible d'être obtenue par ce procédé.

## Description

La présente invention concerne un nouveau procédé de fabrication par LIGA-UV d'une structure métallique multicouche à couches adjacentes non entièrement superposées, ainsi qu'une nouvelle structure métallique multicouche à couches adjacentes non entièrement superposées susceptible d'être obtenue par ce procédé.

DGC Mitteilungen No. 104, 2005, mentionne l'utilisation de la technologie LIGA (LIthographie Galvanik Abformung : méthode conçue par W. Ehrfeld du Karlsruhe Nuclear Research Center, Allemagne) pour la fabrication de pièces métalliques horlogères de haute précision, telles que par exemple des ancres ou des roues d'échappement. Ce procédé présente l'inconvénient de nécessiter un équipement lourd, un synchrotron, pour générer l'irradiation en rayons X. Il ne peut donc être commodément utilisé dans l'industrie horlogère.

A.B. Frazier et al., Journal of Microelectromechanical systems, 2, 2, June 1993, décrit la fabrication de structures métalliques par électrodéposition de métal dans des moules en photorésist à base de polyimide, préparés à l'aide d'un procédé utilisant une technologie appelée LIGA-UV, analogue à la technologie LIGA mais avec une illumination UV à la place de l'irradiation aux rayons X.

Le procédé utilisé pour la fabrication de ces structures métalliques comprend les étapes suivantes :
- créer sur une plaquette support en silicium une couche métallique sacrificielle et une couche d'ensemencement pour l'électrodéposition,
- étaler par dépôt à la tournette (spin-coating) une couche de polyimide photosensible,
- effectuer à travers un masque correspondant à l'empreinte désirée une illumination aux rayons ultraviolets,
- développer en dissolvant les parties non irradiées de façon à obtenir un moule en polyimide,
- déposer galvaniquement du nickel dans la partie ouverte du moule jusqu'à hauteur de celui-ci de façon à obtenir une surface supérieure sensiblement plane,
- déposer par vaporisation sous vide une couche fine de chrome,
- déposer sur cette couche fine de chrome une couche de polyimide photosensible par dépôt à la tournette (spin-coating), et enlever la couche fine de chrome avec une solution d'acide chlorhydrique,
- effectuer une illumination UV à travers un nouveau masque correspondant à l'empreinte désirée, développer en dissolvant les parties non irradiées de façon à obtenir un nouveau moule en polyimide, et déposer galvaniquement du nickel dans la partie ouverte du moule, et
- éliminer la couche sacrificielle et séparer la structure métallique obtenue par électrodéposition du moule en polyimide.

Ce procédé est utilisé pour fabriquer une plaque métallique surmontée d'une protubérance de forme générale parallélépipédique (V. et Fig.9 page 92), la deuxième couche étant entièrement superposée sur la première couche de surface plus grande. Il est mentionné (dernier paragraphe du V. page 93) que la même structure inversée avec la protubérance de forme générale parallélépipédique en dessous de la plaque a également été fabriquée selon la même technique mais la structure effectivement obtenue n'est ni montrée, ni décrite.

La Demanderesse a constaté que la mise en oeuvre d'un tel procédé lorsque la deuxième couche déposée électrolytiquement n'est pas entièrement superposée sur la première couche, conduit à une croissance non verticale du métal déposé et à la formation de bulles au-dessus de la résine.

EP0851295 divulgue un autre procédé de fabrication par LIGA-UV de structures métalliques multicouches proche du procédé enseigné par Frazier et al., appliqué à la fabrication d'une roue dentée surmontée d'un pignon bicouche à couches entièrement superposées (Exemple 1) ou d'un microcapteur de flux thermique tricouche à couches entièrement superposées (Exemple 3). Si ce procédé était utilisé pour fabriquer une structure comportant deux couches adjacentes non entièrement superposées, il présenterait aussi les inconvénients exposés ci-dessus.

Le problème ou but de l'invention est de trouver un procédé de fabrication d'une structure métallique multicouche comportant au moins deux couches adjacentes non entièrement superposées, qui ne présente pas ces inconvénients.

Ce problème est résolu par l'invention telle que définie par les revendications.

La Demanderesse a en effet découvert que dans un procédé tel que celui de Frazier et al. décrit ci-dessus, si l'on effectue le deuxième électroformage sans enlever la couche fine de métal déposée par vaporisation sous vide à la suite du premier électroformage, la croissance du métal s'effectue verticalement et sans formation de bulles au cours de ce deuxième électroformage, même si la deuxième couche n'est pas entièrement superposée sur la première couche.

L'invention concerne ainsi un procédé de fabrication par LIGA-UV d'une structure métallique multicouche comportant au moins une deuxième couche adjacente à une première couche et non entièrement superposée à celle-ci, qui comprend les étapes suivantes :
a) étaler une couche de photorésist sur un substrat,
b) chauffer la couche de photorésist, si nécessaire pour évaporer le solvant,
c) exposer la couche de photorésist à travers un masque correspondant à l'empreinte désirée à une irradiation UV de 100 à 2000 mJ/cm² mesurée à une longueur d'onde de 365 nm,
d) effectuer, si nécessaire pour compléter la photopolymérisation ou la photodécomposition des parties irradiées, un recuit de la couche obtenue à l'issue de l'étape c),
e) procéder au développement par dissolution des parties non photopolymérisées ou photodécomposées, de façon à obtenir un moule de photorésist polymérisé,
f) déposer galvaniquement une première couche d'un métal ou d'un alliage dans les parties ouvertes du moule, et obtenir une surface supérieure sensiblement plane,
g) déposer par vaporisation sous vide une couche métallique d'accrochage sur toute la surface supérieure sensiblement plane, puis reproduire les étapes a), b), c), d) et e),
h) déposer galvaniquement une deuxième couche d'un métal ou d'un alliage dans les parties ouvertes du moule en présence de la couche métallique d'accrochage, et obtenir une surface supérieure sensiblement plane,
i) reproduire, si nécessaire, les étapes g) et h), de façon à former la structure métallique multicouche souhaitée, et
j) détacher du substrat la structure métallique multicouche obtenue et le photorésist polymérisé, séparer le photorésist de façon à libérer la structure métallique multicouche, puis éliminer la partie de la ou des couches métalliques d'accrochage qui n'est pas insérée entre deux couches de métal électrodéposé.

L'expression "une deuxième couche adjacente à une première couche et non entièrement superposée à celle-ci" signifie que le contour de la deuxième couche ne rentre pas entièrement dans l'élévation verticale du contour de la première couche.

Le substrat peut être une plaquette support en silicium recouverte d'une couche métallique sacrificielle et d'une couche d'ensemencement électrolytique, ou recouverte d'une couche métallique sacrificielle agissant comme couche d'ensemencement électrolytique.

Le substrat est avantageusement une plaquette métallique massive, d'épaisseur en général de 1 à 5 mm, formée d'un métal et/ou d'un alliage conducteur apte à ensemencer (démarrer) la réaction d'électroformage en jouant le rôle de cathode. Cette plaquette peut par exemple être constituée de cuivre, de laiton ou d'acier inoxydable. De préférence elle est constituée d'acier inoxydable.

La surface supérieure de la plaquette métallique massive, destinée à être en contact avec le bain électrolytique, peut être polie ou texturée par exemple par microbillage, gravage chimique, mécanique ou par laser.

La plaquette métallique massive est dégraissée et préparée pour l'électroformage par un traitement approprié. Lorsqu'elle est constituée d'acier inox, un traitement approprié consiste par exemple à opérer un dégraissage avec une solution alcaline, suivi d'une neutralisation en milieu acide pour passiver sa surface, rincer à l'eau distillée et sécher.

Le photorésist est soit un photorésist négatif, à base d'une résine susceptible de polymériser sous l'action du rayonnement UV en présence d'un photoinitiateur, soit un photorésist positif, à base d'une résine susceptible de se décomposer sous l'action du rayonnement UV en présence d'un photoinitiateur. Le photorésist négatif est par exemple à base d'une résine époxy, d'une résine isocyanate ou d'une résine acrylique. Une résine époxy avantageuse est la résine époxy octofonctionelle SU-8 (Shell Chemical). Elle est utilisée en général en présence d'un photoinitiateur choisi parmi les sels de triarylsulfonium, par exemples ceux décrits dans les brevets US 4,058,401 et 4,882,245. Le photorésist positif est par exemple à base d'une résine phénolformaldéhydique de type novalaque en présence d'un photoinitiateur DNQ (DiazoNaphtoQuinone).

L'étalement du photorésist peut se faire par dépôt à la tournette (« spin-coating ») ou par une autre technique, telle que par exemple le trempage (« dip coating »), l'application au cylindre (« roller coating »), l'enduction par extrusion-laminage (« extrusion coating »), le revêtement par pulvérisation (« spray coating ») ou encore le laminage (pour les films secs, par exemple à base de résine acrylique). La technique d'étalement préférée est le dépôt à la tournette.

L'épaisseur maximale de photorésist pour induire l'effet recherché (photopolymérisation ou photodécomposition) dans les conditions d'irradiation de l'étape c) est de l'ordre de 1 mm. L'épaisseur maximale de la couche de photorésist qu'on peut étaler en une fois est de l'ordre de 150 µm selon la technique de dépôt à la tournette. Selon l'épaisseur souhaitée du photorésist, on étalera celui-ci sur le substrat métallique massif en une ou plusieurs fois.

Les conditions de chauffage éventuel du photorésist pour éliminer le solvant dans l'étape b) sont choisies en fonction de la nature et de l'épaisseur du photorésist selon les indications de son fabricant. Pour un photorésist à base d'une résine époxy SU-8 et d'épaisseur 140 µm, l'étape b) consiste par exemple à chauffer à 65 °C pendant 5 à 10 minutes, puis à 95 °C pendant une durée de 30 à 60 minutes. Pour un photorésist à base de film sec acrylique, cette étape de chauffage pour évaporer le solvant n'est pas nécessaire.

Dans le cas où il est nécessaire d'étaler le photorésist en plusieurs fois et de chauffer le photorésist pour évaporer le solvant, on effectuera l'étape b) à l'issue de l'étape a) après le premier étalement du photorésist et on reproduira les étapes a) et b) le nombre de fois nécessaire.

L'étape c) consiste à exposer la couche de photorésist à travers un masque correspondant à l'empreinte désirée à une irradiation UV de 100 à 2000 mJ/cm² mesurée à une longueur d'onde de 365 nm. Cette irradiation induit la photopolymérisation de la résine (photorésist négatif) ou la photodécomposition de celle-ci (photorésist positif).

L'étape d) consiste à effectuer, si nécessaire pour compléter la photopolymérisation ou la photodécomposition de l'étape c), un recuit de la couche obtenue à l'issue de cette étape. Pour certains photorésists, par exemple les photorésists à base de film sec acrylique, cette étape de chauffage pour compléter la photopolymérisation n'est pas nécessaire.

L'étape e) consiste à procéder au développement par dissolution des parties non irradiées (photorésist négatif) ou des parties irradiées (photorésist positif) à l'aide d'une solution aqueuse appropriée ou d'un solvant, choisi en fonction de la nature du photorésist selon les indications de son fabricant. Des exemples de solutions aqueuses appropriées sont des solutions alcalines de base faible, par exemple de carbonate de sodium, et des exemples de solvants appropriés sont le GBL (gammabutyrolactone), le PGMEA (propylène glycole méthyle éthyle acétate), et l'isopropanol. On utilise avantageusement comme solvant ou solution de développement pour la résine époxy SU-8 du PGMEA, et pour une résine acrylique une solution de carbonate de sodium 1 % ou de l'isopropanol.

L'étape f) consiste à déposer galvaniquement une première couche d'un métal ou d'un alliage dans les parties ouvertes du moule de photorésist, et obtenir une surface supérieure sensiblement plane.

On utilise fréquemment comme métal pour l'électroformage le nickel, le cuivre, l'or ou l'argent, et comme alliage l'or-cuivre, le nickel-cobalt, le nickel-fer et le nickel-phosphore. On utilise en général le même métal ou le même alliage pendant l'électroformage. Dans certains cas toutefois on utilise successivement plusieurs métaux et/ou alliages au cours de l'électroformage. Les conditions d'électroformage, notamment la composition des bains, la géométrie du système, les tensions et densités de courant, sont choisis pour chaque métal ou alliage à électrodéposer selon les techniques bien connues dans l'art de l'électroformage (cf. par exemple Di Bari G.A. "electroforming" Electroplating Engineering Handbook" 4th Edition rédigé par L.J. Durney, édité par Van Nostrand Reinhold Compagny Inc., N.Y. USA 1984).

Une solution pour obtenir une surface supérieure sensiblement plane est de déposer galvaniquement le métal ou l'alliage jusqu'à la hauteur du moule de photorésist, en surveillant avec précision, par exemple par laser, la montée du niveau de métal électroformé : on parvient ainsi à une surface sensiblement plane avec des irrégularités de sa hauteur de l'ordre de 10 µm. On utilise cette solution lorsque le substrat est une plaquette en silicium, trop fragile pour supporter un usinage de la structure métallique.

Lorsque le substrat est une plaquette métallique massive, il est possible d'usiner la structure métallique et le moule in situ et donc de la mettre à niveau de façon à obtenir une surface supérieure plane au niveau voulu. Il n'est donc alors plus nécessaire de surveiller avec une grande précision la montée du métal électroformé dans le moule. On choisit ce niveau un peu en dessus de l'épaisseur visée (de 10 à 30 µm), et on met ensuite à niveau par usinage, notamment par abrasion et polissage, la structure métallique et le moule de façon à obtenir une surface supérieure plane dont les irrégularités de surface ne dépassent pas 1 µm environ. Cette solution présente l'avantage de permettre une meilleure maîtrise de l'épaisseur dans la mise en oeuvre du procédé et d'améliorer la qualité de la structure obtenue car le dépôt électrolytique ultérieur s'effectue de façon plus régulière sur une surface polie que sur une surface présentant des irrégularités.

L'étape g) consiste à déposer par vaporisation sous vide une couche de métal, appelée ici couche métallique d'accrochage, sur toute la surface supérieure sensiblement plane, puis à reproduire les étapes a), b), c), d) et e).

Cette vaporisation sous vide (PVD) peut se faire dans les conditions habituelles bien connues dans l'art antérieur(cf. par exemple Donald M. Mattox, 1998, "Handbook of Physical Vapor Deposition (PVD) Processing" publié par William Andrew Publishing).

L'épaisseur de la couche métallique d'accrochage est en général de 50 à 500 nm, de préférence de 100 à 300 nm, en particulier de 120 à 250 nm.

Le métal vaporisé est choisi en fonction du métal d'électroformage pour sa capacité d'accrocher au métal électroformé et au photorésist d'une part, d'ensemencer la réaction d'électrodéposition d'autre part. Il peut être par exemple du nickel, du cuivre, de l'or, du chrome sur de l'or ou du nickel sur du titane.

Au cours de l'étape g), les étapes a), b), c), d) et e) sont effectuées de façon semblable à ce qui est décrit ci-dessus pour ces étapes, avec comme substrat dans l'étape a) la couche métallique d'accrochage et en utilisant un nouveau masque correspondant à l'empreinte désirée pour la nouvelle couche. On obtient ainsi un deuxième moule de photorésist polymérisé.

L'étape h) consiste à déposer galvaniquement une deuxième couche d'un métal ou d'un alliage dans les parties ouvertes du deuxième moule, en présence de la couche métallique d'accrochage, et obtenir une surface supérieure sensiblement plane. La présence de la couche métallique d'accrochage permet d'assurer une croissance verticale du métal déposé et d'éviter la formation de bulles. Le métal ou l'alliage de la deuxième couche peut être identique à celui, ou différent de celui, de la première couche. En général il s'agit du même métal ou alliage.

L'étape i) consiste à reproduire, si nécessaire, les étapes g) et h), de façon à obtenir la structure métallique multicouche souhaitée. Cette reproduction n'est pas nécessaire pour la fabrication d'une structure métallique bicouche.

L'étape j) consiste à détacher du substrat la structure métallique multicouche obtenue et le photorésist polymérisé, séparer le photorésist de façon à libérer la structure métallique multicouche, puis éliminer la partie de la ou des couches métalliques d'accrochage qui n'est pas insérée entre deux couches de métal ou alliage électrodéposé.

Lorsque le substrat est une plaquette support en silicium recouverte d'une couche métallique sacrificielle, on détache la structure métallique multicouche et le moule par dissolution de cette couche sacrificielle, en général à l'aide d'une solution acide choisie pour attaquer le métal de la couche sacrificielle sans dégrader le métal ou l'alliage de la structure métallique.

Lorsque le substrat est une plaquette métallique massive, on détache la structure métallique multicouche et le moule par délaminage. La face inférieure de la structure métallique détachée de la face supérieure du substrat métallique massif reproduit l'état de surface de celle-ci. Elle sera ainsi soit texturée (si la face supérieure du substrat métallique est texturée, par exemple par gravage ou microbillage) soit d'aspect poli (si la face supérieure du substrat métallique a subi un polissage). Dans ce dernier cas, à l'observation à l'oeil nu, l'aspect poli de la surface de la face inférieure de la structure ne se distingue pas de l'aspect poli obtenu le cas échéant par polissage sur la surface de la face supérieure. Par observation au microscope optique avec un grossissement de 50 fois, un éclairage adapté et une certaine orientation, ou au microscope électronique à balayage, ou à l'aide de systèmes topographiques d'analyse de surface, on parvient toutefois à distinguer ces deux surfaces.

La séparation ou le stripage du photorésist se fait en général par attaque chimique ou traitement plasmatique.

Après le stripage du photorésist, une partie de la ou des couches métalliques d'accrochage n'est pas insérée entre deux couches de métal électroformé et doit donc être éliminée. Cette élimination s'effectue en général par attaque de ce métal dans un bain approprié qui n'attaque pas le métal électroformé. Par exemple lorsque la couche métallique d'accrochage est de l'or, cette élimination se fait dans un bain de dédorage à base d'une solution cyanurée.

Le procédé de l'invention peut aussi être utilisé pour fabriquer une structure métallique multicouche comportant une couche de métal ou d'alliage entièrement superposée sur ladite deuxième couche. Le métal ou l'alliage de la couche entièrement superposée sur ladite deuxième couche peut être identique à celui, ou différent de celui, de ladite deuxième couche. En général il s'agit du même métal ou alliage.

Pour fabriquer une telle structure, à l'issue de l'étape h) ou de l'étape i) et avant l'étape j), on réalise par LIGA-UV une couche de métal ou d'alliage entièrement superposée sur la couche de métal ou d'alliage déposée en h) ou en i). L'homme du métier trouvera dans l'art antérieur, et en particulier dans Frazier et al. cité ci-dessus, les conditions de dépôt d'une couche métallique entièrement superposée à une couche métallique. Celles-ci peuvent être par exemple les suivantes : on reproduit les étapes a), b), c), d) et e), puis on active par traitement électrochimique la surface du métal électroformé non recouverte de photorésist polymérisé, et on reproduit l'étape h). Cette activation se fait par application d'un courant inverse en faisant jouer au métal électroformé le rôle d'anode selon les techniques bien connues dans l'art du traitement des surfaces. On obtient ainsi une structure métallique multicouche comportant au moins une deuxième couche adjacente à une première couche et non entièrement superposée à celle-ci, et une autre couche entièrement superposée à ladite deuxième couche

Le procédé de l'invention peut aussi être utilisé pour fabriquer une structure métallique multicouche comportant une couche de métal ou d'alliage sur laquelle ladite première couche est entièrement superposée. Le métal ou l'alliage de la couche sur laquelle ladite première couche est entièrement superposée peut être identique à celui, ou différent de celui, de ladite première couche. En général il s'agit du même métal ou alliage.

Pour fabriquer une telle structure, préalablement à l'étape a), on a réalisé par LIGA-UV une couche de métal ou d'alliage sur laquelle ladite première couche de métal ou d'alliage est entièrement superposée. L'homme du métier trouvera dans l'art antérieur, et en particulier dans Frazier et al. cité ci-dessus, les conditions de dépôt d'une couche métallique entièrement superposée à une couche métallique. Les conditions de ce dépôt peuvent être par exemple les suivantes : on effectue les étapes a), b), c), d) et e), puis on active par traitement électrochimique la surface du métal électroformé non recouverte de photorésist polymérisé, et on effectue l'étape h). On obtient ainsi une structure métallique multicouche comportant au moins une deuxième couche adjacente à une première couche et non entièrement superposée à celle-ci, et une autre couche sur laquelle ladite première couche est entièrement superposée.

Le procédé de l'invention permet de fabriquer par LIGA-UV des structures métalliques comportant au moins une deuxième couche adjacente à une première couche et non entièrement superposée à celle-ci, qui n'ont pas de défauts dus à la formation de bulles et à une croissance non verticale du métal électroformé. De telles structures ne pouvaient être obtenues avec les procédés connus.

L'invention concerne ainsi également une nouvelle structure métallique multicouche comportant au moins une deuxième couche adjacente à une première couche et non entièrement superposée à celle-ci, susceptible d'être obtenue par le procédé défini ci-dessus.

D'autres particularités et avantages de l'invention apparaîtront à la lecture de la description détaillée qui va suivre, en référence aux dessins annexés, qui illustrent schématiquement et à titre d'exemple, quelques formes d'exécution du procédé de l'invention.

Dans ces dessins:
- les Figures 1A à 1C sont respectivement une vue en perspective de dessous, une vue en perspective de dessus et une vue en coupe selon la ligne AB de la vue en perspective de dessous, d'un pont d'ancre pour échappement de mouvement d'horlogerie, structure bicouche à couches non entièrement superposées
- les Figures 2A à 2I sont des vues en coupe représentant les différentes étapes de la fabrication du pont d'ancre des Figures 1A à 1C,
- les Figures 3A et 3B sont respectivement une vue en coupe et une vue de dessus d'un doigt de quantième, structure bicouche à couches non entièrement superposées,
- les Figures 4A et 4B sont respectivement une vue en coupe et une vue de dessus d'une entretoise, structure tricouche à deuxième couche non entièrement superposée sur la première couche et troisième couche entièrement superposée sur la deuxième couche.

Les exemples ci-après décrivent la fabrication selon le procédé de l'invention de ce pont d'ancre, ce doigt de quantième et cette entretoise, en référence à ces figures.

### Exemple 1 : Fabrication d'un pont d'ancre

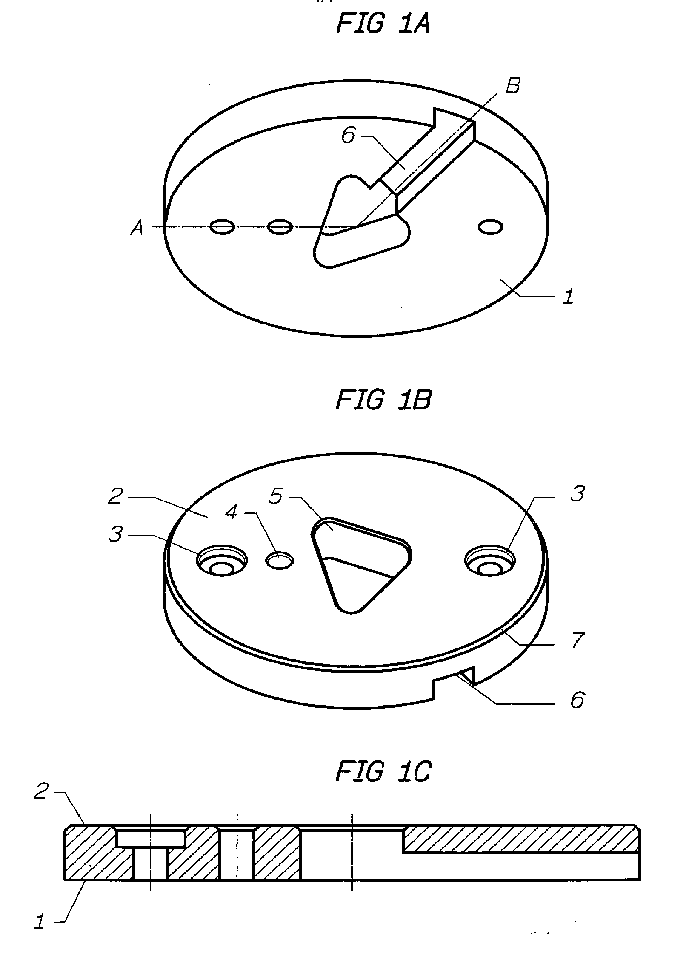

Les Figures 1A, 1B et 1C représentent un pont d'ancre comprenant une face inférieure 1, une face supérieure 2, un trou cylindrique dégagé 3, un trou cylindrique 4, un trou de forme 5, un dégagement 6 et des parties anglées 7.

Les dimensions de ce pont d'ancre sont les suivantes : épaisseur du premier niveau 0,25 mm (± 5 µm), épaisseur du deuxième niveau 0,22 mm (± 5 µm), épaisseur totale 0,47 mm (± 10 µm), diamètre du trou cylindrique 4 0,606 mm (± 2 µm), diamètre du trou cylindrique dégagé 3 1,36 mm (± 10 µm), diamètre extérieur total de la pièce 6,5 mm.

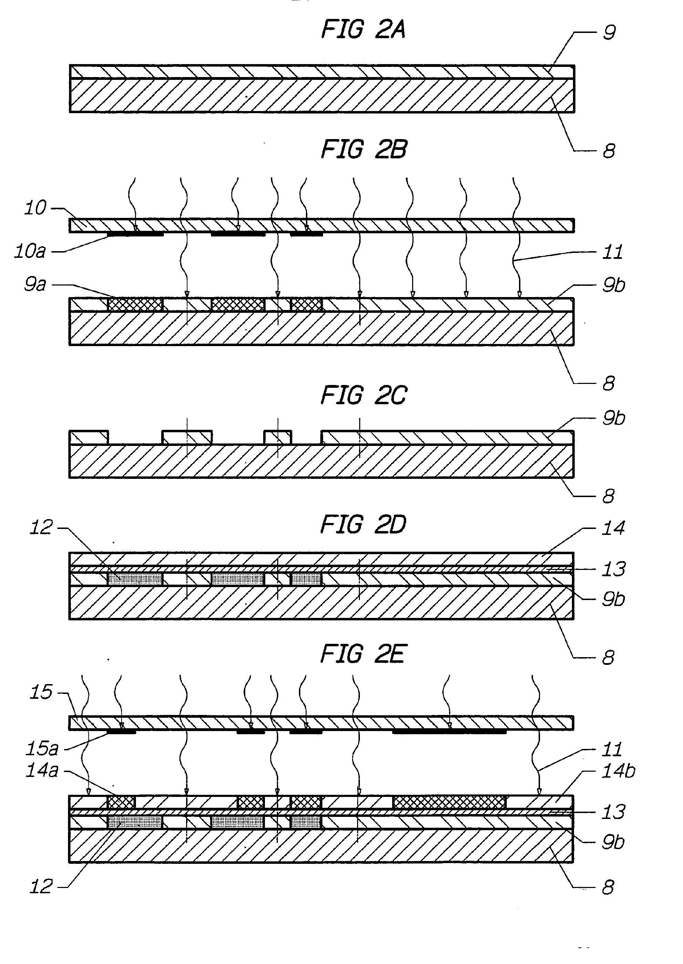

A la Figure 2A on a représenté la structure obtenue à l'issue de l'étape b), qui comprend une couche de photorésist 9 recouvrant le substrat 8. Cette structure a été obtenue selon le protocole décrit ci-après.

Un substrat 8 formé d'une plaquette en acier inox de 1 mm d'épaisseur et de 150 mm de diamètre, a été dégraissé et préparé pour l'électroformage par dégraissage avec une solution alcaline, suivi d'une neutralisation en milieu acide pour passiver sa surface, puis rinçage à l'eau distillée et séchage. On a ensuite procédé à l'étalement sur le substrat 8 par dépôt à la tournette d'une première couche de photorésist négatif à base de résine époxy octofonctionelle SU-8 de 140 µm d'épaisseur, puis au chauffage pour évaporation du solvant pendant 5 minutes à 65 °C, puis 35 minutes à 95°C. On a ensuite procédé à l'étalement sur la première couche de photorésist par dépôt à la tournette d'une deuxième couche du même photorésist de 140 µm d'épaisseur, puis au chauffage pour évaporation du solvant pendant 7 minutes à 65 °C, puis 60 minutes à 95°C.

La Figure 2B correspond à l'étape c) d'illumination UV d'environ 600 mJ/cm² centrée à 365 nm, du photorésist à travers un masque correspondant à l'empreinte désirée. On distingue sur cette figure le masque comportant un support 10 transparent aux UV et des zones opaques 10a formées par des dépôts de chrome. Le même support formant le masque peut comporter un grand nombre de zones correspondant à autant de structures pouvant être fabriquées en un seul lot, toutes les zones étant obtenues avec une très haute résolution du contour par photolithographie, technique bien connue dans l'industrie microélectronique.

Cette irradiation induit la photopolymérisation de la résine dans les zones exposées 9b, les zones non exposées 9a restant non polymérisées.

La Figure 2C montre la structure obtenue à l'issue de l'étape e).

On a effectué un recuit de la couche obtenue à l'issue de l'étape c) pour compléter la polymérisation pendant 1 minute à 65 °C, puis 15 minutes à 95 °C, puis dissolution du photorésist non exposé par passage pendant 15 minutes dans trois bains successifs de PGMEA (de pureté croissante), rinçage dans un bain d'alcool isopropylique et séchage. On distingue dans la Figure 2C le moule 9b en photorésist polymérisé superposé sur le substrat 8.

La Figure 2D montre la structure obtenue après reproduction des étapes a) et b).

On a effectué au cours de l'étape f) le dépôt galvanique de nickel dans les parties ouvertes du moule de photorésist polymérisé, et une mise à niveau par abrasion et polissage de façon à obtenir une surface supérieure plane, puis déposé par vaporisation sous vide une couche d'or d'environ 200 nm et reproduit les étapes a) et b) avec deux couches successives de 125 µm du même photorésist à base de résine époxy SU-8, chauffage pendant 5 minutes à 65 °C puis 35 minutes à 95 °C pour la première couche, et chauffage pendant 7 minutes à 65 °C puis 60 minutes à 95 °C pour la deuxième couche.

On distingue sur la Figure 2D la couche de photorésist 14 au-dessus de la couche d'or 13 recouvrant le photorésist polymérisé 9b et la couche électroformée 12, au-dessus du substrat 8.

La Figure 2E correspond à la reproduction de l'étape c) avec une illumination UV d'environ 550 mJ/cm² centrée à 365 nm, du photorésist à travers un nouveau masque correspondant à l'empreinte désirée. On distingue sur cette figure le masque comportant un support 15 transparent aux UV et des zones opaques 15a formées par des dépôts de chrome. Cette irradiation par rayons UV 11 induit la photopolymérisation de la résine dans les zones exposées 14b, les zones non exposées 14a restant non polymérisées.

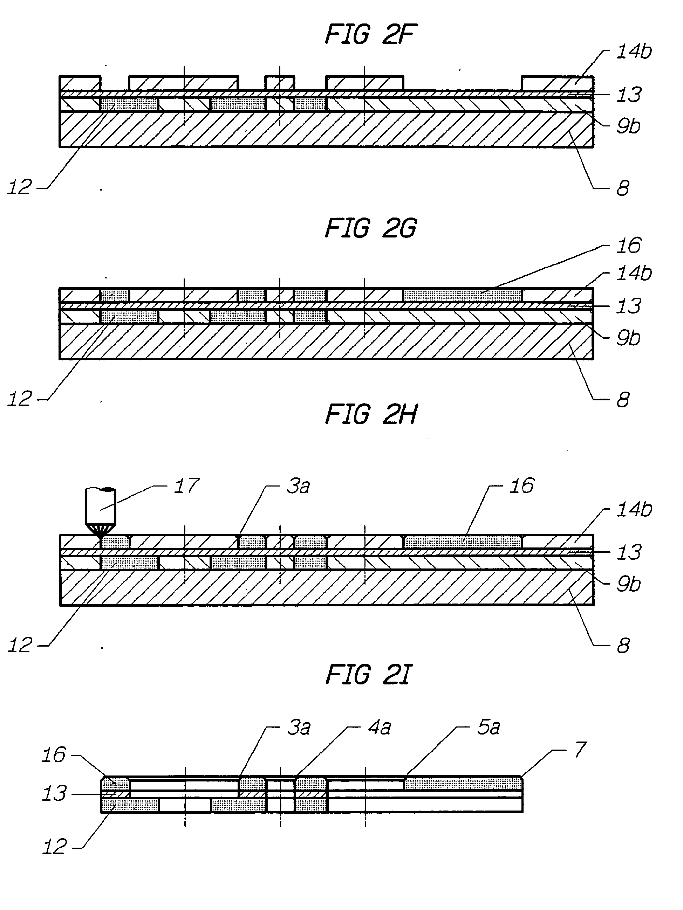

La Figure 2F montre la structure obtenue à l'issue de l'étape g). On a effectué un recuit de la couche obtenue à l'issue de la reproduction de l'étape c) pour compléter la polymérisation pendant 1 minute à 65 °C, puis 15 minutes à 95 °C, puis dissout le photorésist non exposé par passage pendant 15 minutes dans trois bains successifs de PGMEA (de pureté croissante), rinçage dans un bain d'alcool isopropylique et séchage. On distingue dans cette figure le deuxième moule de photorésist polymérisé 14b au-dessus de la couche métallique d'accrochage 13, au-dessus du premier moule de photorésist polymérisé 9b et la couche de nickel électroformé 12, au-dessus du substrat 8.

La Figure 2G montre la structure obtenue à l'issue de l'étape h). On a effectué un deuxième dépôt galvanique de nickel jusqu'à une hauteur légèrement supérieure (de 10 à 30 µm) à l'épaisseur visée, puis mis à niveau par abrasion et polissage de façon à obtenir une surface supérieure plane. On distingue sur cette figure le deuxième moule de résine polymérisée 14b et la deuxième couche électroformée 16, au-dessus de la couche métallique d'accrochage 13, au-dessus du premier moule polymérisé 9b et de la première couche électroformée 12, au-dessus du substrat 8.

La Figure 2H montre une opération d'anglage effectuée sur la structure obtenue à l'issue de l'étape h). On distingue sur cette figure (de plus par rapport à la Figure 2G) une fraise 17 et un trou anglé 3a.

La Figure 2I, qui correspond à la vue en coupe de la Figure 1C, montre le pont d'ancre obtenu à l'issue de l'étape j), après détachage du substrat métallique par délaminage, élimination du photorésist polymérisé par un traitement plasmatique et stripage par dédorage de la partie de la couche d'or non insérée entre les deux couches de nickel électrodéposé. On distingue sur cette figure la première couche de nickel 12, la couche d'or 13, la deuxième couche de nickel 16, et les anglages 3a, 4a, 5a et 7.

### Exemple 2 : Fabrication d'un doigt de quantième

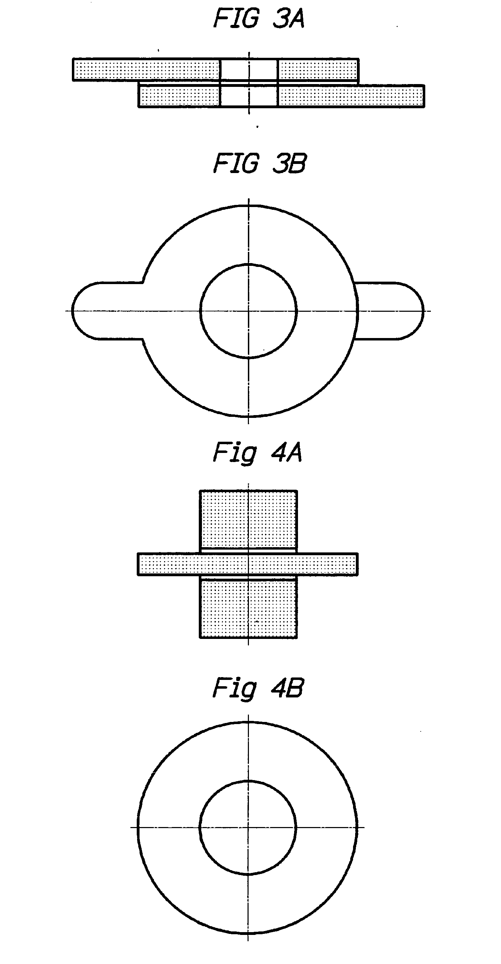

Les Figures 3A et 3B représentent un doigt de quantième. Les dimensions de celui-ci sont les suivantes : épaisseur de la première couche 0,38 mm (± 5 µm), épaisseur de la deuxième couche 0.33 (± 5 µm), épaisseur totale 0,71 mm (± 10 µm), diamètre du trou intérieur 1,346 (± 2 µm) diamètre extérieur 1,95 mm (± 10 µm) et longueur du doigt 0,5 mm (± 10 µm).

Ce doigt de quantième a été préparé comme décrit ci-dessous.

Un substrat formé d'une plaquette en acier inox de 1 mm d'épaisseur et de 150 mm de diamètre, a été dégraissé et préparé pour l'électroformage par dégraissage avec une solution alcaline, suivi d'une neutralisation en milieu acide pour passiver sa surface, puis rinçage à l'eau distillée et séchage. On a ensuite procédé à l'étalement sur le substrat par dépôt à la tournette d'une première couche de photorésist négatif à base de résine époxy octofonctionelle SU-8 (Shell Chemical) de 140 µm d'épaisseur, puis au chauffage pour évaporation du solvant pendant 5 minutes à 65 °C, puis 35 minutes à 95 °C. On a ensuite procédé à l'étalement sur la première couche de photorésist par dépôt à la tournette d'une deuxième couche du même photorésist de 140 µm d'épaisseur, puis chauffage pour évaporation du solvant pendant 7 minutes à 65 °C, puis 60 minutes à 95°C, puis d'une troisième couche du même photorésist de 140 µm d'épaisseur, puis chauffage par évaporation pendant 10 minutes à 60 °C, puis 80 minutes à 65°C

On a ensuite effectué l'étape c) avec une illumination UV d'environ 750 mJ/cm² centrée à 365 nm du photorésist à travers un masque correspondant à l'empreinte désirée. Cette irradiation induit la photopolymérisation de la résine dans les zones exposées, les zones non exposées restant non polymérisées.

On a ensuite effectué un recuit de la couche obtenue pour compléter la polymérisation pendant 2 minutes à 65 °C, puis 20 minutes à 95 °C, puis on a dissout le photorésist non exposé par passage pendant 20 minutes dans trois bains successifs de PGMEA (de pureté croissante), rinçage dans un bain d'alcool isopropylique et séchage. On a ainsi obtenu un moule de photorésist polymérisé au-dessus du substrat en inox.

On a ensuite effectué le dépôt galvanique de nickel dans les parties ouvertes du moule de photorésist polymérisé, et une mise à niveau par abrasion et polissage de façon à obtenir une surface supérieure plane, déposé par vaporisation sous vide une couche d'or d'environ 200 nm et reproduit les étapes a) et b) avec trois couches successives de 120 µm du même photorésist à base de résine époxy SU-8, chauffage pendant 5 minutes à 65 °C puis 35 minutes à 95 °C pour la première couche, chauffage pendant 7 minutes à 65 °C puis 60 minutes à 95 °C pour la deuxième couche, et chauffage pendant 8 minutes à 65 °C, puis 70 minutes à 95 °C pour la troisième couche.

On a ensuite reproduit l'étape c) avec une illumination UV d'environ 700 mJ/cm² centrée à 365 nm, du photorésist à travers un nouveau masque correspondant à l'empreinte désirée. Cette irradiation par rayons UV induit la photopolymérisation de la résine dans les zones exposées, les zones non exposées restant non polymérisées.

On a ensuite effectué un recuit pour compléter la polymérisation pendant 1 minute à 65 °C, puis 15 minutes à 95 °C, puis dissout le photorésist non exposé par passage pendant 15 minutes dans trois bains successifs de PGMEA (de pureté croissante), rinçage dans un bain d'alcool isopropylique et séchage. On a ainsi obtenu un deuxième moule de photorésist polymérisé, au-dessus de la couche d'or d'accrochage, au-dessus du premier moule de photorésist polymérisé et de la couche de nickel électroformé, au-dessus du substrat.

On a ensuite effectué un deuxième dépôt galvanique de nickel jusqu'à une hauteur légèrement supérieure à l'épaisseur visée (de 10 à 30 µm), puis mis à niveau par abrasion et polissage de façon à obtenir une surface supérieure plane.

On a ensuite détaché le substrat de la structure métallique par délaminage, éliminé le photorésist polymérisé par un traitement plasmatique et éliminé la couche d'or en contact avec l'extérieur par dédorage. On a ainsi obtenu le doigt de quantième représenté sur les Figures 3A et 3B.

### Exemple 3 : Fabrication d'une entretoise

Les Figures 4A et 4B représentent une entretoise. Les dimensions de celle-ci sont les suivantes : épaisseur du premier niveau 0,25 mm (± 5 µm), épaisseur du deuxième niveau 0,15 mm (± 5 µm), épaisseur du troisième niveau 0,15 mm (± 5 µm), épaisseur totale 0,55 mm (± 15 µm); diamètres du premier et troisième niveau 1,00 mm (±3 µm), diamètre du deuxième niveau 3,5 mm (± 7 µm).

Un substrat formé d'une plaquette en acier inox de 1 mm d'épaisseur et de 150 mm de diamètre, a été dégraissé et préparé pour l'électroformage par dégraissage avec une solution alcaline, neutralisation avec une solution acide pour passiver sa surface, puis rinçage à l'eau distillée et séchage. On a ensuite procédé à l'étalement sur le substrat par dépôt à la tournette d'une première couche de photorésist négatif à base de résine époxy octofonctionelle SU-8 de 140 µm d'épaisseur, puis au chauffage pour évaporation du solvant pendant 5 minutes à 65 °C, puis 35 minutes à 95 °C. On a ensuite procédé à l'étalement sur la première couche de photorésist par dépôt à la tournette d'une deuxième couche du même photorésist de 140 µm d'épaisseur, puis au chauffage pour évaporation du solvant pendant 7 minutes à 65 °C, puis 60 minutes à 95°C.

On a ensuite effectué l'étape c) avec une illumination UV d'environ 600 mJ/cm² centrée à 365 nm du photorésist à travers un masque correspondant à l'empreinte désirée. Cette irradiation induit la photopolymérisation de la résine dans les zones exposées, les zones non exposées restant non polymérisées.

On a ensuite effectué un recuit de la couche obtenue pour compléter la polymérisation pendant 1 minutes à 65 °C, puis 15 minutes à 95 °C, puis on a dissout le photorésist non exposé par passage pendant 15 minutes dans trois bains successifs de PGMEA (de pureté croissante), rinçage dans un bain d'alcool isopropylique et séchage. On a ainsi obtenu un moule de photorésist polymérisé au-dessus du substrat en inox.

On a ensuite effectué le dépôt galvanique de nickel dans les parties ouvertes du moule de photorésist polymérisé, et une mise à niveau par abrasion et polissage de façon à obtenir une surface supérieure plane, déposé par vaporisation sous vide une couche d'or d'environ 150 nm et reproduit les étapes a) et b) avec deux couches successives de 90 µm du même photorésist à base de résine époxy SU-8, chauffage pendant 5 minutes à 65 °C puis 20 minutes à 95 °C pour la première couche, et chauffage pendant 7 minutes à 65 °C puis 60 minutes à 95 °C pour la deuxième couche.

On a ensuite reproduit l'étape c) avec une illumination UV d'environ 500 mJ/cm² centrée à 365 nm, du photorésist à travers un nouveau masque correspondant à l'empreinte désirée. Cette irradiation par rayons UV induit la photopolymérisation de la résine dans les zones exposées, les zones non exposées restant non polymérisées.

On a ensuite effectué un recuit pour compléter la polymérisation pendant 1 minute à 65 °C, puis 15 minutes à 95 °C, puis dissout le photorésist non exposé par passage pendant 15 minutes dans trois bains successifs de PGMEA (de pureté croissante), rinçage dans un bain d'alcool isopropylique et séchage. On a ainsi obtenu un deuxième moule de photorésist polymérisé, au-dessus de la couche d'or d'accrochage, au-dessus du premier moule de photorésist polymérisé et de la couche de nickel électroformé, au-dessus du substrat.

On a ensuite effectué un deuxième dépôt galvanique de nickel jusqu'à une hauteur légèrement supérieure (de 10 à 30 µm) à la hauteur visée , puis mis à niveau par abrasion et polissage de façon à obtenir une surface supérieure plane.

On a reproduit les étapes a) et b) avec deux couches successives de 140 µm du même photorésist à base de résine époxy SU-8, chauffage pendant 5 minutes à 65 °C puis 35 minutes à 95 °C pour la première couche, et chauffage pendant 7 minutes à 45 °C puis 60 minutes à 95 °C pour la deuxième couche.

On a ensuite reproduit l'étape c) avec une illumination UV d'environ 600 mJ/cm² centrée à 365 nm, du photorésist à travers un nouveau masque correspondant à l'empreinte désirée. Cette irradiation par rayons UV induit la photopolymérisation de la résine dans les zones exposées, les zones non exposées restant non polymérisées.

On a ensuite effectué un recuit pour compléter la polymérisation pendant 1 minute à 65 °C, puis 15 minutes à 95 °C, puis dissout le photorésist non exposé par passage pendant 15 minutes dans trois bains successifs de PGMEA (de pureté croissante), rinçage dans un bain d'alcool isopropylique et séchage. On a ainsi obtenu un troisième moule de photorésist polymérisé au-dessus du premier de la deuxième couche de nickel électroformé.

On a activé par traitement électrochimique la surface supérieure de cette deuxième couche de nickel électroformée non recouverte de photorésist polymérisé.

On a ensuite effectué un deuxième dépôt galvanique de nickel jusqu'à une hauteur légèrement supérieure (de 10 à 30 µm) à celle de la hauteur visée, puis mis à niveau par abrasion et polissage de façon à obtenir une surface supérieure plane.

On a ensuite détaché le substrat de la structure métallique par délaminage, éliminé le photorésist polymérisé par un traitement plasmatique et éliminé la couche d'or en contact avec l'extérieur par dédorage. On a ainsi obtenu l'entretoise représentée sur les Figures 4A et 4B.

## Revendications

1. Procédé de fabrication par LIGA-UV d'une structure métallique multicouche comportant au moins une deuxième couche adjacente à une première couche et non entièrement superposée à celle-ci, qui comprend les étapes suivantes :
a) étaler une couche de photorésist sur un substrat,
b) chauffer la couche de photorésist, si nécessaire pour évaporer le solvant,
c) exposer la couche de photorésist à travers un masque correspondant à l'empreinte désirée à une irradiation UV de 100 à 2000 mJ/cm² mesurée à une longueur d'onde de 365 nm,
d) effectuer, si nécessaire pour compléter la photopolymérisation ou la photodécomposition des parties irradiées, un recuit de la couche obtenue à l'issue de l'étape c),
e) procéder au développement par dissolution des parties non photopolymérisées ou photodécomposées, de façon à obtenir un moule de photorésist polymérisé,
f) déposer galvaniquement une première couche d'un métal ou d'un alliage dans les parties ouvertes du moule, et obtenir une surface supérieure sensiblement plane,
g) déposer par vaporisation sous vide une couche métallique d'accrochage sur toute la surface supérieure sensiblement plane, puis reproduire les étapes a), b), c), d) et e),
h) déposer galvaniquement une deuxième couche d'un métal ou d'un alliage dans les parties ouvertes du moule en présence de la couche métallique d'accrochage, et obtenir une surface supérieure sensiblement plane,
i) reproduire, si nécessaire, les étapes g) et h), de façon à former la structure métallique multicouche souhaitée, et
j) détacher du substrat la structure métallique multicouche obtenue et le photorésist polymérisé, séparer le photorésist de façon à libérer la structure métallique multicouche, puis éliminer la partie de la ou des couches métalliques d'accrochage qui n'est pas insérée entre deux couches de métal électrodéposé.

2. Procédé selon la revendication 1, **caractérisé en ce qu'**à l'issue de l'étape h) ou de l'étape i), et avant l'étape j), on réalise par LIGA-UV une couche de métal ou d'alliage entièrement superposée sur la couche de métal ou d'alliage déposée en h) ou en i).

3. Procédé selon la revendication 1, **caractérisé en ce que** préalablement à l'étape a), on a réalisé par LIGA-UV une couche de métal ou d'alliage sur laquelle ladite première couche de métal ou d'alliage est entièrement superposée.

4. Procédé selon l'une des revendications précédentes 1, **caractérisé en ce que** le substrat est une plaquette métallique massive.

5. Procédé selon l'une des revendications précédentes, **caractérisé en ce que** le substrat est une plaquette en acier inoxydable.

6. Procédé selon l'une des revendications 4 et 5 **caractérisé en ce que** la plaquette a une surface supérieure texturée, par microbillage, gravage chimique, mécanique ou par laser.

7. Procédé selon l'une des revendications 4 et 5 **caractérisé en ce que** la plaquette a une surface supérieure polie.

8. Procédé selon l'une des revendications 4 à 7 **caractérisé en ce que** dans l'étape f) et/ou l'étape h), on met à niveau par usinage la structure métallique et le moule de façon à obtenir une surface supérieure plane.

9. Structure métallique multicouche comportant au moins une deuxième couche adjacente à une première couche et non entièrement superposée à celle-ci susceptible d'être obtenue selon l'une des revendications 1 à 8.

10. Structure métallique selon la revendication 8 **caractérisée en ce qu'**elle est une pièce d'horlogerie, en particulier un pont d'ancre, un doigt de quantième ou une entretoise.
